# EUROPEAN PATENT SPECIFICATION

(11) **EP 2 938 570 B1**
(45) Date of publication and mention of the grant of the patent: **11.12.2019**
(21) Application number: 13799699.7
(22) Date of filing: 30.10.2013
(51) Int. Cl.: B81B 7/00

(54) **SURFACE CHARGE MITIGATION LAYER FOR MEMS SENSORS**
OBERFLÄCHENLADUNGSMINDERUNGSSCHICHT FÜR MEMS-SENSOREN
COUCHE D'ATTÉNUATION DE CHARGE SURFACIQUE POUR DES CAPTEURS À MEMS

(30) Priority: 01.11.2012 US 201261721088 P
(43) Date of publication of application: 04.11.2015
(73) Proprietor: Robert Bosch GmbH, 70442 Stuttgart (DE)
(72) Inventor: GRAHAM, Andrew, Redwood City, CA 94062 (US); FEYH, Ando, Palo Alto, CA 94306 (US); O'BRIEN, Gary, Palo Alto, CA 94304 (US)
(86) International application number: PCT/US2013/067576
(87) International publication number: WO 2014/070930

(56) References cited:
- WO-A1-2006/102460
- FOURMUN LEE ET AL: "Atomic Layer Deposition: An Enabling Technology for Microelectronic Device Manufacturing", ADVANCED SEMICONDUCTOR MANUFACTURING CONFERENCE, 2007. ASMC 2007. IEEE/SEMI, IEEE, PISCATAWAY, NJ, USA, 1 June 2007 (2007-06-01), pages 359-365, XP031182992, ISBN: 978-1-4244-0652-4

## Description

### TECHNICAL FIELD

This disclosure relates to a semiconductor device as defined in the preamble of claim 1 and to a method of fabricating a semiconductor device as defined in the preamble of claim 9 with regard to prior art document WO 2006/102460 A1.

### BACKGROUND

For a wide range of sensor devices, variations in surface charge and sudden changes in surface charge can couple into the transduction mechanism of the sensor and adversely affect the sensor output. For example, some sensor devices, such as capacitive sensor devices, utilize electrodes to indicate changes in an electrical characteristic, e.g., capacitance, that are directly or indirectly the result of changes in a sensed condition. In such sensors, variations in surface charge can alter the bias of the electrodes and result in inconsistent changes in the response of the sensor. Even with the inclusion of an insulating material, surface charges can be problematic for sensitive measurements.

WO 2006/102460 A1 describes Systems and methods for shielding integrated circuits from electromagnetic or electrostatic fields by locating an active device layer between two conductors that are electrically coupled together.

The publication "Atomic Layer Deposition: An Enabling Technology for Microelectronic Device Manufacturing" by Fourmun Lee et al., ADVANCED SEMICONDUCTOR MANUFACTORING CONFERENCE, 2007. ASMC 2007. IEEE/SEMI, IEEE, PISCATAWAY, NJ, USA, 1 June 2007, pages 359-365, XP031182992, ISBN 978-1-4244-0652-4 describes applications of atomic layer deposition in the fabrication of gate stacks, on-chip capacitors, and thin film magnetic heads.

To reduce the effects of variations and sudden changes in surface charge, sensor devices are often provided with a grounded, conductive layer on top of the sensor that is configured to direct surface charges away from the sensitive elements of the sensor. However, some sensor devices have configurations that preclude the use of traditional materials and/or deposition methods in forming a conductive layer on the device for surface charge dispersal. For example, microelectromechanical systems (MEMS) sensor devices have micro- and nanoscale mechanical structures that are configured to move in response to a sensed condition to produce a sensor output. Conductive layers that are deposited using traditional materials and/or methods often have mechanical properties that can interfere with the functionality of MEMS structures due to mechanical effects (e.g., stress, fatigue over lifetime testing, stiffness effects, etc.).

Traditional conductive layers may be formed of a material and/or be deposited at a thickness that results in an increased effective stiffness of the MEMS structures which can dampen or even prevent the movement of the MEMS structures as a result. Even films of several 10's of nanometers thickness can have adverse effects on the functionality of MEMS structures. Traditional materials and/or methods may also result in conductive layers with low conformality and/or discontinuities, especially on structures with extremely varying topology. Such low conformality and discontinuities, even of a very small nature, can have large impact on the sensor performance. Additionally, devices requiring optical transmission may suffer greatly depending on the material in question.

### DRAWINGS

FIG. 1 shows a cross-sectional view of a capacitive pressure sensor prior to the formation of a surface charge mitigation layer in accordance with the present disclosure.
FIG. 2 shows a cross-sectional view of the capacitive pressure sensor of FIG. 1 after the formation of a surface charge mitigation layer.
FIG. 3 shows a cross-sectional view of the capacitive pressure sensor of FIG. 2 after a surface charge mitigation layer has been deposited and patterned.
FIG. 4 shows a surface charge mitigation layer deposited using atomic layer deposition (ALD) over a surface having extreme topological variations and surface roughness.

### DESCRIPTION

For many devices, such as MEMS sensors, small changes in surface charge can impact the output. To mitigate surface charge effects in a MEMS sensor, the present disclosure proposes the use of an extremely thin conductive layer referred to herein as a surface charge mitigation layer, deposited onto the surface of the sensor and connected to grounded contacts that are located far away from the sensitive structures of the MEMS sensor. The grounded surface charge mitigation layer can further be used as a shield against external electric fields, which may influence the sensor functionality negatively.

In accordance with one embodiment, a semiconductor device includes a substrate. At least one transducer is provided on the substrate. The at least one transducer includes at least one electrically conductive circuit element. A dielectric layer is deposited onto the substrate over the at least one transducer. A surface charge mitigation layer formed of a conductive material is deposited onto the outer surface of the dielectric layer with the surface charge mitigation layer being electrically coupled to ground potential.

In accordance with another embodiment, a method of fabricating a semiconductor device includes providing at least one transducer on a substrate. The transducer has at least one electrically conductive circuit element. A dielectric layer is deposited onto the substrate over the at least one transducer. A surface charge mitigation layer formed of a conductive material is deposited onto an outer surface of the dielectric layer. The surface charge mitigation layer is then coupled to ground potential.

The surface charge mitigation layer may be deposited to a thickness of 10nm or less, and in some cases, 5nm or less, and may be deposited using atomic layer deposition (ALD) although other deposition methods may also be used, such as chemical vapor deposition, plating, electroless deposition, self-assembled monolayers, or other available techniques for creating such thin layers.

The transducer is a device that is configured to receive one form of energy as an input and to output another form of energy as a measure of the input energy. As an example, a transducer may comprise a microelectromechanical systems (MEMS) device, such as a capacitive MEMS pressure sensor, and may be configured to implement a certain type of device, such as a microphone. The surface charge mitigation layer may be patterned to include pores to alter the properties of the mitigation layer based on the type of transducer or MEMS device implemented on the substrate. For example, the mitigation layer may be patterned to include pores and openings to enhance flexibility in order to minimize mechanical impact on any underlying movable MEMS components. The mitigation layer may also be patterned to provide certain optical properties in the mitigation layer, such as transmission, reflectance, focusing, and the like, as required for the functionality of any components provided on the substrate.

The surface charge mitigation layer is formed of a conductive material. Examples of conductive materials that may be used for the surface charge mitigation layer include platinum (Pt), aluminum (Al), titanium (Ti), and titanium nitride (TiN), tantalum nitride (TaN), and the like, although other suitable metal materials may be used. In one embodiment, the mitigation layer is deposited at a thickness of 10nm or less and in some cases at 5nm or less. In alternative embodiments, the surface charge mitigation layer may be formed at any suitable thickness taking the type of MEMS structures of the sensor into consideration. The surface charge mitigation layer can be deposited using atomic layer deposition (ALD), chemical vapor deposition (CVD), plating, electroless deposition, self-assembled monolayers, or other available techniques for creating such thin layers.

The deposition methods used to form the surface charge mitigation layer, particularly ALD, enables a continuous, conductive film to be formed on the structures of the MEMS sensor that has high conformality and uniformity even on structures with extremely varying topology. This is very important for micro- and nanoscale devices where small mechanical variations can have large impact on the sensor performance. Because such films can be effective even at thicknesses of 5nm, their mechanical impact on most structures (even microscale ones) would be negligible. In addition, the patterning of such a layer allows for further reductions in mechanical impact while also allowing additional possibilities for optical transmission based on the wavelength and film pattern.

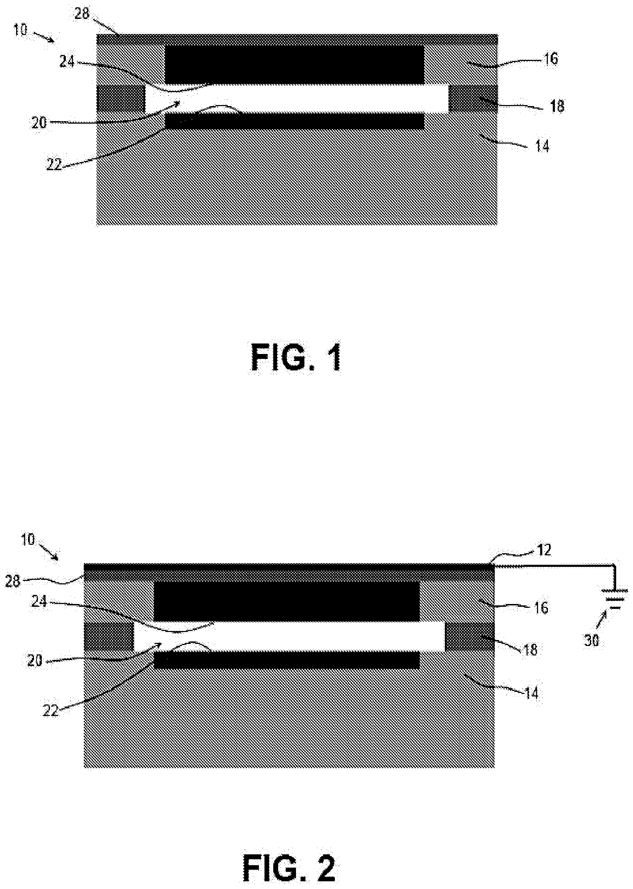

FIG. 1 depicts an exemplary embodiment of a device 10 onto which a surface charge mitigation layer 12 (FIG. 2) in accordance with the present disclosure can be formed. The device 10 in FIG. 1 includes a transducer having at least one electrically conductive circuit element, e.g., electrodes 22, 24. In one embodiment, the transducer comprises a MEMS device, such as a capacitive MEMS pressures sensor which can be used to implement a microphone. FIG. 1 depicts the device 10 prior to the formation of the surface charge mitigation layer 12. Although a capacitive MEMS pressure sensor is shown and described herein, the use of the surface charge mitigation layer 12 may be applied to substantially any type of MEMS sensor device or other sensor device that could benefit from surface charge mitigation.

The device 10 includes a bulk silicon layer 14 and a cap layer 16. In the embodiment of FIG. 1, the bulk silicon layer 14 is provided in a substrate, such as a silicon wafer. The cap layer 16 is suspended above the substrate by a support layer 18 that forms a cavity 20 between the cap layer 16 and the silicon layer 14 and that electrically isolates the cap layer 16 from the substrate. The cavity 20 defines a capacitive gap for the sensor and is typically provided at or near vacuum. In other embodiments, the cavity 20 is at a pressure level other than at or near vacuum, depending on the operating environment of the pressure sensor, among other factors.

The bulk silicon layer 14 includes a lower electrode 22 formed in a sensing region of the substrate that is configured to serve as the fixed electrode of the capacitive pressure sensor. The lower electrode 22 may be formed in any suitable manner, such as by the deposition of a conductive film, electrical isolation of a conductive layer, adding a spacer layer between two conductive layers, and implant doping of the silicon substrate. The exact implementation of the lower electrode 22 in the substrate depends in part on the desired performance characteristics of the device 10 and the processes and materials used to fabricate the structures that define the sensor.

In one embodiment, the cap layer 16 comprises an epitaxial deposition of polysilicon that forms a flexible membrane that is suspended over the lower electrode 22. The conductive polysilicon of the cap layer 16 enables the membrane to serve as the movable electrode 24 for the capacitive pressure sensor, also referred to herein as the upper electrode. During fabrication of the device 10, the cap layer 16 is deposited onto a sacrificial oxide layer (not shown) formed on the substrate in the area of the fixed electrode 22. The sacrificial layer is then removed between cap layer 16 and the substrate to form the cavity 20 and to release the membrane.

In the embodiment of FIGS. 1-3, an insulating layer 28 is formed on top of the cap layer 16. The insulating layer 28 is formed of a suitable dielectric material, including various oxides and polymers, and may be deposited in any suitable manner that allows the desired layer thickness. The insulating layer 28 may also be configured as a sealing layer in order to seal the cap layer 16 and protect the cavity 20 from contamination.

The deformable membrane 16 is configured to deflect toward the substrate under an applied pressure which alters the gap between the fixed electrode 22 and the movable electrode 24, resulting in a change in the capacitance between the two electrodes 22, 24. The fixed electrode 22 is electrically connected to the measurement circuitry (not shown) for the sensor. The measurement circuitry is configured to monitor the capacitance between the fixed electrode 22 and the movable electrode 24 to detect changes in capacitance that result from the deflection of the movable electrode 24 in response to changes in pressure. By monitoring the change in capacitance between the fixed electrode 22 and the movable electrode 24, a magnitude of a pressure applied to the deformable membrane can be determined.

FIG. 2 depicts the device 10 of FIG. 1 after the formation of a surface charge mitigation layer 12. In one embodiment, the surface charge mitigation layer 12 is deposited at a thickness of 10nm or less. In another embodiment, the mitigation layer 12 is deposited at a thickness of 5nm or less. The surface charge mitigation layer 12 is electrically connected to grounded contacts (not shown) that are located a suitable distance apart from the MEMS components. As depicted in FIGS. 1-3, the surface charge mitigation layer 12 is connected to ground 30 at a location that is spaced apart from the device 10. This enables the surface charge mitigation layer 12 to gather stray charges that may be present in the vicinity of the device 10 and direct them away from the device 10 to ground where they can be safely dissipated.

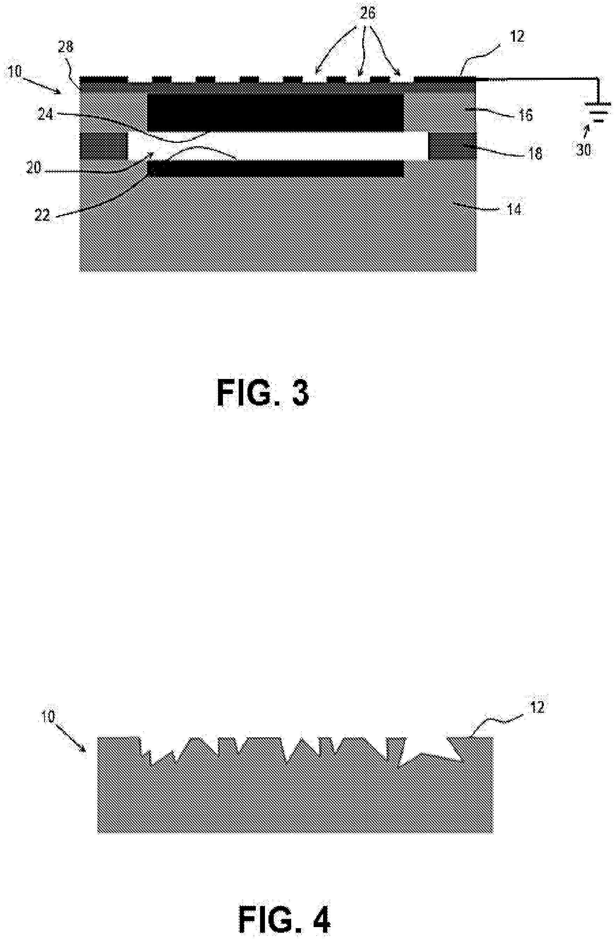

The surface charge mitigation layer 12 is deposited using an ALD process. Alternatively, the surface charge mitigation layer 12 can be deposited using chemical vapor deposition, plating, electroless deposition, self-assembled monolayers, or other available techniques capable of forming such thin layers. The thin film deposition methods mentioned above, such as ALD, enables a continuous, conductive film to be formed on the device 10 that has high conformality and uniformity even on surfaces with extremely varying topology as depicted in FIG. 4.

The surface charge mitigation layer 12 is patterned to form pores 26 as depicted in FIG. 3 to further reduce the mechanical impact of the mitigation layer 12 on the MEMS structures. The surface charge mitigation layer 12 of FIG. 3 may be formed in substantially the same manner and at the same thickness as depicted in FIG. 2. The surface charge mitigation layer 12 is patterned, such as by etching, to form pores and openings in the mitigation layer.

The patterning may be used to alter the properties of the mitigation layer based on the type of transducer or MEMS device implemented on the substrate.The mitigation layer is patterned to include pores and can comprise openings that enhance flexibility in order to minimize mechanical impact on any underlying movable MEMS components. The mitigation layer may also be patterned to provide certain optical properties in the mitigation layer, such as transmission, reflectance, focusing, and the like, as required for the functionality of any optically sensitive components provided on the substrate, such as infrared radiation sensors and the like. The porosity of the mitigation layer should not be such that the ability to conduct surface charges away from the sensor is affected. Any suitable pattern may be implemented in the mitigation layer 12, including a mesh, grid, and array patterns, meandering patterns, or other arbitrary patterns, that are capable of imparting desired characteristics to the mitigation layer.

## Claims

1. A semiconductor device (10) comprising:
a substrate;
at least one transducer provided on the substrate, the at least one transducer including at least one electrically conductive circuit element; and
a dielectric layer deposited onto the substrate over the at least one transducer, the dielectric layer including an outer surface that faces away from the substrate; and
a surface charge mitigation layer (12) formed of a conductive material deposited onto the outer surface of the dielectric layer, the surface charge mitigation layer (12) being electrically coupled to ground potential;
**characterized in that** the surface charge mitigation layer (12) is patterned to form pores to alter a flexibility of the surface charge mitigation layer (12) and/or an optical property of the surface charge mitigation layer (12).

2. The device (10) of claim 1, wherein the surface charge mitigation layer (12) has a thickness of approximately 10nm or less.

3. The device (10) of claim 2, wherein the surface charge mitigation layer (12) has a thickness of 5nm or less.

4. The device (10) of claim 2, wherein the surface charge mitigation layer (12) is deposited using an atomic layer deposition (ALD) process.

5. The device (10) of claim 2, wherein the surface charge mitigation layer (12) is formed of one of platinum, aluminum, titanium, and titanium nitride.

6. The device (10) of claim 2, wherein the at least one transducer comprises a microelectromechanical systems (MEMS) device.

7. The device (10) of claim 6, wherein the MEMS device comprises a MEMS pressure sensor.

8. The device (10) of claim 6, wherein the MEMS pressure sensor includes a lower electrode (22) deposited onto the substrate and a cap layer (16) deposited onto the substrate and suspended over the lower electrode (22), the cap layer (16) forming a flexible membrane (16) with an upper electrode (24), and
wherein the dielectric layer is deposited onto the cap layer (16).

9. A method of fabricating a semiconductor device (10) comprising:
providing at least one transducer on a substrate, the transducer including at least one electrically conductive circuit element;
depositing a dielectric layer onto the substrate over the at least one transducer, the dielectric layer including an outer surface that faces away from the substrate; and
depositing a surface charge mitigation layer (12) formed of a conductive material onto the outer surface of the dielectric layer; and
coupling the surface charge mitigation layer (12) to ground potential;
**characterized in that** the surface charge mitigation layer (12) is patterned to form pores to alter a flexibility of the surface charge mitigation layer (12) and/or an optical property of the surface charge mitigation layer (12).

10. The method of claim 9, wherein the surface charge mitigation layer (12) is deposited to a thickness of approximately 10nm or less.

11. The method of claim 10, wherein the surface charge mitigation layer (12) is deposited to a thickness of 5nm or less.

12. The method of claim 10, wherein the surface charge mitigation layer (12) is deposited using an atomic layer deposition (ALD) process.

13. The method of claim 10, wherein the surface charge mitigation layer (12) is formed of one of platinum, aluminum, titanium, and titanium nitride.

14. The method of claim 10, wherein the at least one transducer comprises a microelectromechanical systems, MEMS, pressure sensor.

15. The method of claim 14, wherein the MEMS pressure sensor includes a lower electrode (22) deposited onto the substrate and a cap layer (16) deposited onto the substrate and suspended over the lower electrode (22), the cap layer (16) forming a flexible membrane (16) with an upper electrode (24), and
wherein the dielectric layer is deposited onto the cap layer (16).

## Patentansprüche

1. Halbleitervorrichtung (10), umfassend:
ein Substrat;
mindestens einen Wandler, der auf dem Substrat vorgesehen ist, wobei der mindestens eine Wandler mindestens ein elektrisch leitendes Schaltungselement aufweist; und
eine dielektrische Schicht (28), die auf dem Substrat über dem mindestens einen Wandler abgeschieden ist, wobei die dielektrische Schicht (28) eine Außenfläche aufweist, die von dem Substrat abgewandt ist; und
eine Oberflächenladungsminderungsschicht (12), die von einem leitfähigen Material gebildet ist, das auf der Außenfläche der dielektrischen Schicht (28) abgeschieden ist, wobei die Oberflächenladungsminderungsschicht (12) mit Erdpotential elektrisch gekoppelt ist;
**dadurch gekennzeichnet, dass** die Oberflächenladungsminderungsschicht (12) gemustert wird, um Poren zu bilden, um eine Flexibilität der Oberflächenladungsminderungsschicht (12) und/oder eine optische Eigenschaft der Oberflächenladungsminderungsschicht (12) zu verändern.

2. Vorrichtung (10) nach Anspruch 1, wobei die Oberflächenladungsminderungsschicht (12) eine Dicke von ungefähr 10 nm oder weniger aufweist.

3. Vorrichtung (10) nach Anspruch 2, wobei die Oberflächenladungsminderungsschicht (12) eine Dicke von 5 nm oder weniger aufweist.

4. Vorrichtung (10) nach Anspruch 2, wobei die Oberflächenladungsminderungsschicht (12) mithilfe eines Atomlagenabscheidungs- (ALD-) Prozesses abgeschieden ist.

5. Vorrichtung (10) nach Anspruch 2, wobei die Oberflächenladungsminderungsschicht (12) von einem von Platin, Aluminium, Titan und Titannitrid gebildet ist.

6. Vorrichtung (10) nach Anspruch 2, wobei der mindestens eine Wandler eine Mikroelektromechaniksystem- (MEMS-) Vorrichtung umfasst.

7. Vorrichtung (10) nach Anspruch 6, wobei die MEMS-Vorrichtung einen MEMS-Drucksensor umfasst.

8. Vorrichtung (10) nach Anspruch 6, wobei der MEMS-Drucksensor eine untere Elektrode (22), die auf dem Substrat abgeschieden ist, und eine Deckschicht (16), die auf dem Substrat abgeschieden ist und über der unteren Elektrode (22) hängt, aufweist, wobei die Deckschicht (16) eine flexible Membran (16) mit einer oberen Elektrode (24) bildet, und wobei die dielektrische Schicht auf der Deckschicht (16) abgeschieden ist.

9. Verfahren zur Herstellung einer Halbleitervorrichtung (10), umfassend:
Vorsehen mindestens eines Wandlers auf einem Substrat, wobei der Wandler mindestens ein elektrisch leitendes Schaltungselement aufweist;
Abscheiden einer dielektrischen Schicht (28) auf dem Substrat über dem mindestens einen Wandler, wobei die dielektrische Schicht (28) eine Außenfläche aufweist, die von dem Substrat abgewandt ist; und
Abscheiden einer Oberflächenladungsminderungsschicht (12), die von einem leitfähigen Material gebildet ist, auf der Außenfläche der dielektrischen Schicht (28); und Koppeln der Oberflächenladungsminderungsschicht (12) mit Erdpotential;
**dadurch gekennzeichnet, dass** die Oberflächenladungsminderungsschicht (12) gemustert wird, um Poren zu bilden, um eine Flexibilität der Oberflächenladungsminderungsschicht (12) und/oder eine optische Eigenschaft der Oberflächenladungsminderungsschicht (12) zu verändern.

10. Verfahren nach Anspruch 9, wobei die Oberflächenladungsminderungsschicht (12) auf eine Dicke von ungefähr 10 nm oder weniger abgeschieden wird.

11. Verfahren nach Anspruch 10, wobei die Oberflächenladungsminderungsschicht (12) auf eine Dicke von 5 nm oder weniger abgeschieden wird.

12. Verfahren nach Anspruch 10, wobei die Oberflächenladungsminderungsschicht (12) mithilfe eines Atomlagenabscheidungs- (ALD-) Prozesses abgeschieden wird.

13. Verfahren nach Anspruch 10, wobei die Oberflächenladungsminderungsschicht (12) von einem von Platin, Aluminium, Titan und Titannitrid gebildet wird.

14. Verfahren nach Anspruch 10, wobei der mindestens eine Wandler einen Mikroelektromechaniksystem-, MEMS-, Drucksensor umfasst.

15. Verfahren nach Anspruch 14, wobei der MEMS-Drucksensor eine untere Elektrode (22), die auf dem Substrat abgeschieden ist, und eine Deckschicht (16), die auf dem Substrat abgeschieden ist und über der unteren Elektrode (22) hängt, aufweist, wobei die Deckschicht (16) eine flexible Membran (16) mit einer oberen Elektrode (24) bildet, und wobei die dielektrische Schicht auf der Deckschicht (16) abgeschieden wird.

## Revendications

1. Dispositif semi-conducteur (10) comprenant :
un substrat ;
au moins un transducteur disposé sur le substrat, l'au moins un transducteur comportant au moins un élément de circuit électriquement conducteur ; et
une couche diélectrique (28) déposée sur le substrat par-dessus l'au moins un transducteur, la couche diélectrique (28) comportant une surface externe qui tourne le dos au substrat ; et
une couche d'atténuation de charge surfacique (12) constituée d'un matériau conducteur déposée sur la surface externe de la couche diélectrique (28), la couche d'atténuation de charge surfacique (12) étant électriquement couplée à un potentiel de terre ;
**caractérisé en ce que** la couche d'atténuation de charge surfacique (12) est structurée pour former des pores pour modifier une flexibilité de la couche d'atténuation de charge surfacique (12) et/ou une propriété optique de la couche d'atténuation de charge surfacique (12).

2. Dispositif (10) de la revendication 1, dans lequel la couche d'atténuation de charge surfacique (12) a une épaisseur d'environ 10 nm ou moins.

3. Dispositif (10) de la revendication 2, dans lequel la couche d'atténuation de charge surfacique (12) a une épaisseur de 5 nm ou moins.

4. Dispositif (10) de la revendication 2, dans lequel la couche d'atténuation de charge surfacique (12) est déposée au moyen d'un procédé de dépôt de couches atomiques (ALD).

5. Dispositif (10) de la revendication 2, dans lequel la couche d'atténuation de charge surfacique (12) est constituée d'un matériau parmi le platine, l'aluminium, le titane, et le nitrure de titane.

6. Dispositif (10) de la revendication 2, dans lequel l'au moins un transducteur comprend un dispositif à systèmes microélectromécaniques (MEMS).

7. Dispositif (10) de la revendication 6, dans lequel le dispositif MEMS comprend un capteur de pression MEMS.

8. Dispositif (10) de la revendication 6, dans lequel le capteur de pression MEMS comporte une électrode inférieure (22) déposée sur le substrat et une couche d'encapsulation (16) déposée sur le substrat et suspendue au-dessus de l'électrode inférieure (22), la couche d'encapsulation (16) formant une membrane flexible (16) avec une électrode supérieure (24), et
dans lequel la couche diélectrique est déposée sur la couche d'encapsulation (16).

9. Procédé de fabrication d'un dispositif semi-conducteur (10) comprenant :
l'obtention d'au moins un transducteur sur un substrat, le transducteur comportant au moins un élément de circuit électriquement conducteur ;
le dépôt d'une couche diélectrique (28) sur le substrat par-dessus l'au moins un transducteur, la couche diélectrique (28) comportant une surface externe qui tourne le dos au substrat ; et
le dépôt d'une couche d'atténuation de charge surfacique (12) constituée d'un matériau conducteur sur la surface externe de la couche diélectrique (28) ; et
le couplage de la couche d'atténuation de charge surfacique (12) à un potentiel de terre ;
**caractérisé en ce que** la couche d'atténuation de charge surfacique (12) est structurée pour former des pores pour modifier une flexibilité de la couche d'atténuation de charge surfacique (12) et/ou une propriété optique de la couche d'atténuation de charge surfacique (12).

10. Procédé de la revendication 9, dans lequel la couche d'atténuation de charge surfacique (12) est déposée jusqu'à une épaisseur d'environ 10 nm ou moins.

11. Procédé de la revendication 10, dans lequel la couche d'atténuation de charge surfacique (12) est déposée jusqu'à une épaisseur de 5 nm ou moins.

12. Procédé de la revendication 10, dans lequel la couche d'atténuation de charge surfacique (12) est déposée au moyen d'un procédé de dépôt de couches atomiques (ALD).

13. Procédé de la revendication 10, dans lequel la couche d'atténuation de charge surfacique (12) est constituée d'un matériau parmi le platine, l'aluminium, le titane, et le nitrure de titane.

14. Procédé de la revendication 10, dans lequel l'au moins un transducteur comprend un capteur de pression à systèmes microélectromécaniques, MEMS.

15. Procédé de la revendication 14, dans lequel le capteur de pression MEMS comporte une électrode inférieure (22) déposée sur le substrat et une couche d'encapsulation (16) déposée sur le substrat et suspendue au-dessus de l'électrode inférieure (22), la couche d'encapsulation (16) formant une membrane flexible (16) avec une électrode supérieure (24), et
dans lequel la couche diélectrique est déposée sur la couche d'encapsulation (16).
